# EUROPEAN PATENT SPECIFICATION

(11) **EP 4 279 929 B1**
(45) Date of publication and mention of the grant of the patent: **21.05.2025**
(21) Application number: 21920281.9
(22) Date of filing: 22.01.2021
(51) Int. Cl.: G01R 31/00, H02S 40/32, G01R 31/40, H02M 7/49

(54) **DETECTION METHOD AND RELATED DEVICE**
DETEKTIONSVERFAHREN UND ZUGEHÖRIGE VORRICHTUNG
PROCÉDÉ DE DÉTECTION ET DISPOSITIF ASSOCIÉ

(43) Date of publication of application: 22.11.2023
(73) Proprietor: Huawei Digital Power Technologies Co., Ltd., Shenzhen, Guangdong 518043 (CN)
(72) Inventor: XU, Zhiwu, Shenzhen, Guangdong 518129 (CN); GUO, Haibin, Shenzhen, Guangdong 518129 (CN); LI, Lin, Shenzhen, Guangdong 518129 (CN)
(74) Representative: Epping - Hermann - Fischer
(86) International application number: PCT/CN2021/073255
(87) International publication number: WO 2022/155883

(56) References cited:
- EP-B1- 2 536 018
- WO-A1-2020/099157
- CN-A- 104 796 082
- CN-A- 106 771 834
- CN-A- 107 247 213
- CN-A- 107 771 288
- CN-A- 110 708 014
- CN-A- 111 123 051
- CN-A- 111 543 004
- CN-U- 204 046 512
- JP-A- 2004 241 789
- US-B2- 8 760 896

## Description

### TECHNICAL FIELD

### BACKGROUND

In actual application of converters, output ends of the converters are usually combined by using a combiner device and then output, so that a high-power scenario can be met, and unified management is also facilitated. The document US 8 760 896 B2 discloses a primary controller in combination with first and second converters whose respective output is connected to a combiner device. When outputs of the converters are combined, there is a specific requirement for a group of combiner devices to which a preselected device is to be connected. This is to ensure, in one aspect, that power distribution meets a design requirement. In another aspect, because input forms of the converters are different, it is also required that the outputs should not be connected together, or otherwise, a system cannot be started and even a device is damaged. The foregoing combiner devices include but are not limited to a combiner power distribution cabinet, a transformer cabinet, and another device with a combining function.

Based on the foregoing requirements, after a wire of the converter is connected on an application site, a wiring error needs to be identified in advance, to prevent an accident caused by the wiring error.

Currently, whether an output end of the converter is correctly connected to a corresponding combiner device is determined by detecting an output end voltage of the converter and a voltage of a combiner point. However, in this method, the combiner device needs to be capable of detecting voltage information of the combiner point, and this method cannot be implemented for a combiner device with no related voltage detection module.

### SUMMARY

Embodiments of this application provide a detection method and a related apparatus, so that whether there is a wiring error in a combiner system of converters can be quickly and accurately determined in an application scenario in which voltage information at a combiner point cannot be obtained.

According to a first aspect, an embodiment of this application provides a detection method, including: A primary controller obtains an output port voltage signal of a first converter when the first converter is working and a second converter is not working; the primary controller obtains an output port voltage signal of the second converter; and the primary controller generates first information if the output port voltage signal of the first converter and the output port voltage signal of the second converter meet a preset matching relationship, where the first information indicates that an output port of the first converter and an output port of the second converter are connected to a same combiner device; or the primary controller generates second information if the output port voltage signal of the first converter and the output port voltage signal of the second converter do not meet a preset matching relationship, where the second information indicates that the output port of the first converter and the output port of the second converter are connected to different combiner devices, and that a wire connection of the first converter is incorrect or a wire connection of the second converter is incorrect.

In this embodiment of this application, in the detection method, in an application scenario in which voltage information at a combiner point cannot be obtained, whether the first converter and the second converter are connected to a same combiner device can be determined by determining the output port voltage signal of the first converter and the output port voltage signal of the second converter, so that the first information or the second information is generated and notified to staff. Generally, if a first converter and a second converter in a combiner system are not connected to a same combiner device, it may be considered as that a wire connection of the first converter or the second converter is incorrect. Therefore, in the detection method provided in this embodiment of this application, whether there is a wiring error in the combiner system of the converters can be quickly and accurately determined.

With reference to the first aspect, in an implementation provided in this embodiment of this application, before the primary controller indicates the first converter to start working, the method further includes: The primary controller determines the first converter from a plurality of converters in a combiner system according to an input instruction, where the combiner system includes the first converter, the second converter, and a combiner device configured to combine the plurality of converters. In this implementation, if the primary controller pre-determines a master (the first converter) and a slave (the second converter) from the plurality of converters in the combiner system, all slaves perform a determining procedure in the first aspect with the master, and this is a specific implementation. In addition, in this implementation, the master is working but the slaves are not working. Therefore, when all the slaves perform the determining procedure in the first aspect with the master, the master does not need to be shut down but keeps working, so that connection statuses of all converters can be determined quickly and orderly.

With reference to the first aspect, in an implementation provided in this embodiment of this application, the combiner device for combining the plurality of converters is one of a combiner power distribution cabinet and a split winding transformer. In this implementation, a specific type of the combiner device is provided, so that the solution provided in this embodiment of this application is more comprehensive.

With reference to the first aspect, in an implementation provided in this embodiment of this application, the voltage signal is one of a direct-current signal, an alternating-current signal, or a preset-waveform signal. In this implementation, a specific type of the voltage signal is provided, so that the solution provided in this embodiment of this application is more comprehensive.

With reference to the first aspect, in an implementation provided in this embodiment of this application, the converter is one of a direct current-to-direct current converter, a direct current-to-alternating current converter, or an alternating current-to-direct current converter. In this implementation, a specific type of the converter is provided, so that the solution provided in this embodiment of this application is more comprehensive.

With reference to the first aspect, in an implementation provided in this embodiment of this application, the primary controller communicates with the first converter and the second converter by using a wireless signal or in a wired manner. In this implementation, a communication manner between the primary controller and each converter is provided, so that the solution provided in this embodiment of this application is more comprehensive.

With reference to the first aspect, in an implementation provided in this embodiment of this application, the matching relationship is one of an amplitude relationship, a phase relationship, or a frequency relationship. In this implementation, a specific form of the matching relationship is provided, so that the solution provided in this embodiment of this application is more comprehensive.

With reference to the first aspect, in an implementation provided in this embodiment of this application, that the output port voltage signal of the first converter and the output port voltage signal of the second converter meet a preset matching relationship specifically includes: A difference between a component amplitude of an output port voltage of the first converter at a specified frequency and a component amplitude of an output port voltage of the second converter at the specified frequency is less than a preset fault threshold. That the output port voltage signal of the first converter and the output port voltage signal of the second converter do not meet a preset matching relationship specifically includes: The difference between the component amplitude of the output port voltage of the first converter at the specified frequency and the component amplitude of the output port voltage of the second converter at the specified frequency is not less than the preset fault threshold. In this implementation, a specific determining condition corresponding to the output port voltage signal of the first converter and the output port voltage signal of the second converter is provided, so that the solution provided in this embodiment of this application is more comprehensive.

According to a second aspect, an embodiment of this application provides a primary controller, including a processor, a memory, and a communication interface. The memory stores a computer program. The communication interface is configured to communicate with a converter. The processor is configured to execute the computer program stored in the memory, so that the primary controller implements the method in the first aspect.

According to a third aspect, an embodiment of this application provides a detection apparatus. The apparatus includes: an obtaining module, configured to obtain an output port voltage signal of a first converter and an output port voltage signal of the second converter when the first converter is working and the second converter is not working; and a processing module, configured to generate first information when the output port voltage signal of the first converter and the output port voltage signal of the second converter meet a preset matching relationship, where the first information indicates that an output port of the first converter and an output port of the second converter are connected to a same combiner device. The processing module is further configured to generate second information when the output port voltage signal of the first converter and the output port voltage signal of the second converter do not meet the preset matching relationship, where the second information indicates that the output port of the first converter and the output port of the second converter are connected to different combiner devices, and that a wire connection of the first converter is incorrect or a wire connection of the second converter is incorrect. For technical effects of the apparatus in the third aspect of this application, refer to related effects of the method part in the first aspect for understanding. Details are not described herein again.

With reference to the third aspect, in an implementation provided in this embodiment of this application, the processing module is further configured to determine the first converter from a plurality of converters in a combiner system according to an input instruction, where the combiner system includes the first converter, the second converter, and a combiner device configured to combine the plurality of converters.

With reference to the third aspect, in an implementation provided in this embodiment of this application, the combiner device for combining the plurality of converters is one of a combiner power distribution cabinet and a split winding transformer.

With reference to the third aspect, in an implementation provided in this embodiment of this application, the voltage signal is one of a direct-current signal, an alternating-current signal, or a preset-waveform signal.

With reference to the third aspect, in an implementation provided in this embodiment of this application, the converter is one of a direct current-to-direct current converter, a direct current-to-alternating current converter, or an alternating current-to-direct current converter.

With reference to the third aspect, in an implementation provided in this embodiment of this application, the communication interface communicates with the first converter and the second converter by using a wireless signal or in a wired manner.

With reference to the third aspect, in an implementation provided in this embodiment of this application, the matching relationship is one of an amplitude relationship, a phase relationship, or a frequency relationship.

With reference to the third aspect, in an implementation provided in this embodiment of this application, that the output port voltage signal of the first converter and the output port voltage signal of the second converter meet a preset matching relationship specifically includes: A difference between a component amplitude of an output port voltage of the first converter at a specified frequency and a component amplitude of an output port voltage of the second converter at the specified frequency is less than a preset fault threshold. That the output port voltage signal of the first converter and the output port voltage signal of the second converter do not meet a preset matching relationship specifically includes: The difference between the component amplitude of the output port voltage of the first converter at the specified frequency and the component amplitude of the output port voltage of the second converter at the specified frequency is not less than the preset fault threshold.

### BRIEF DESCRIPTION OF DRAWINGS

FIG. 1 is a schematic diagram of a wiring status;
FIG. 2 is a flowchart of a detection method according to an embodiment of this application;
FIG. 3 is a schematic diagram of a system architecture in an application example according to this application;
FIG. 4 is a schematic diagram of detection steps for a combiner system 1 in an application example according to this application;
FIG. 5 is a schematic diagram of detection steps for a combiner system 2 in an application example according to this application;
FIG. 6 is a schematic diagram of a detection apparatus according to an embodiment of this application; and
FIG. 7 is a schematic diagram of an architecture of a primary controller according to an embodiment of this application.

### DESCRIPTION OF EMBODIMENTS

The following describes in detail technical solutions in embodiments of this application with reference to the accompanying drawings in embodiments of this application.

In actual application of converters, output ends of the converters are usually combined by using a combiner device and then output, so that a high-power scenario can be met, and unified management is also facilitated. When outputs of the converters are combined, there is a specific requirement for a group of combiner devices to which a preselected device is to be connected. This is to ensure, in one aspect, that power distribution meets a design requirement. In another aspect, because input forms of the converters are different, it is also required that the outputs should not be connected together, or otherwise, a system cannot be started and even a device is damaged. The foregoing combiner devices include but are not limited to a combiner power distribution cabinet, a transformer cabinet, and another device with a combining function. Based on the foregoing requirements, after a wire of the converter is connected on an application site, a wiring error needs to be identified in advance.

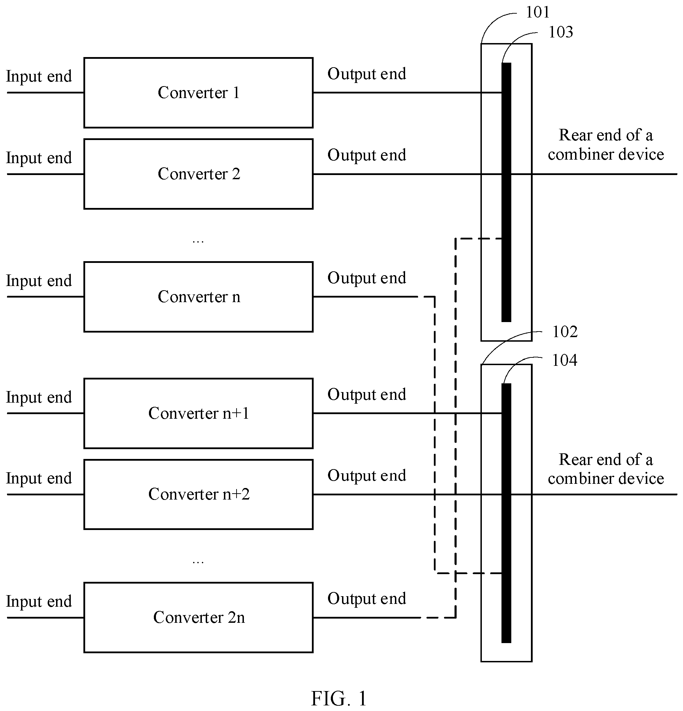

For clear descriptions of the following embodiments, a meaning of the wiring error is first described in detail. FIG. 1 is a schematic diagram of a wiring status. In FIG. 1, a converter 1, a converter 2, ..., and a converter n all need to be connected to a combiner device 101 (the converter 1 to the converter n need to be combined by using the combiner device 101), and a converter n+1, a converter n+2, ..., and a converter 2n all need to be connected to a combiner device 102 (the converter n+1 to the converter 2n are combined by using the combiner device 102). However, when a wiring error occurs when staff connect a wire to the converter, a wire of the converter n may be shown as a dashed line, and is incorrectly connected to the combiner device 102 (a wire connection of the converter n is incorrect, and the converter n is incorrectly connected to the combiner device 102), and a wire of the converter 2n may also be shown as a dashed line, and is incorrectly connected to the combiner device 101 (a wire connection of the converter 2n is incorrect, and the converter 2n is incorrectly connected to the combiner device 101). The error shown by the dashed line in FIG. 1 may be understood as a wiring error. In actual application, another error may also occur, for example, no wire is connected or a wire is disconnected. This may also be understood as the wiring error. This is not limited in this embodiment of this application.

Currently, a solution to the wiring error is generally as follows: After a rear end of a combiner device is powered on at different times, whether there is a wiring error is determined based on a relationship between an output end voltage of a converter and a voltage at a combiner point. Specifically, a system includes a central control unit (a primary controller for short), and the primary controller can collect output end voltages of all converters and a rear end voltage of the combiner device. After it is detected that a voltage at a combiner point of the combiner device is stable, the output end voltages of all the converters are collected. If a voltage at a port of a converter connected to the combiner device 101 and the voltage at the combiner point meet a preset relationship, a wire connection of the converter is correct; otherwise, it is determined that the wire connection of the converter is incorrect. Similarly, same determining is performed for the combiner device 102. As shown in FIG. 1, a combiner point 103 of the combiner device 101 is connected to the converter 1 to a converter n-1, the converter n is incorrectly connected to a combiner point 104 of the combiner device 102, the combiner point 104 of the combiner device 102 is connected to the converter n+1 to a converter 2n-1, and the converter 2n is incorrectly connected to the combiner point 103 of the combiner device 101. In this case, the primary controller may collect output end voltages of all the converters and rear end voltages of the combiner devices (that is, voltages at combiner points of the combiner devices), and then the primary controller determines whether a voltage at a port of the converter and the voltage at the combiner point meet the preset relationship. Generally, a voltage at a port of the converter n and the voltage at the combiner point do not meet the preset relationship, and therefore the primary controller may determine, based on this case, that a wire connection of the converter n is incorrect. Similarly, it can be determined that a wire connection of the converter 2n is incorrect.

However, this solution is not compatible with all combiner devices. For example, two or more groups of low-voltage windings of a split winding transformer may be considered as different combiner devices, and a plurality of groups of combiner devices cannot be powered on at different times. For another example, the rear end of the combiner device is a load and cannot provide a stable voltage.

Another solution is: A converter outputs a voltage under control, and performs determining based on a relationship between an output end voltage of the converter and a voltage at a combiner point. A system includes a primary controller, and the primary controller controls and presets an output voltage of the converter 1 connected to the combiner device 101. If a voltage at the combiner point 103 of the combiner device 101 and the output voltage of the converter 1 meet a preset relationship, a wire connection of the converter is correct; otherwise, it is determined that the wire connection of the converter is incorrect. Similarly, same determining is performed on another preset converter connected to the combiner device 101 and another preset converter connected to another combiner device, so that whether wire connections of converters are correct can be determined one by one.

However, disadvantages of the foregoing two solutions are that voltage information at the combiner point needs to be obtained. In current application scenarios of most conventional combiner devices, voltage information at a combiner point often cannot be obtained because generally no detection module is disposed in the conventional combiner device to measure the voltage information at the combiner point. Therefore, to implement the foregoing two solutions, a module for obtaining the voltage information at the combiner point needs to be additionally installed, and high costs are required for reconstruction.

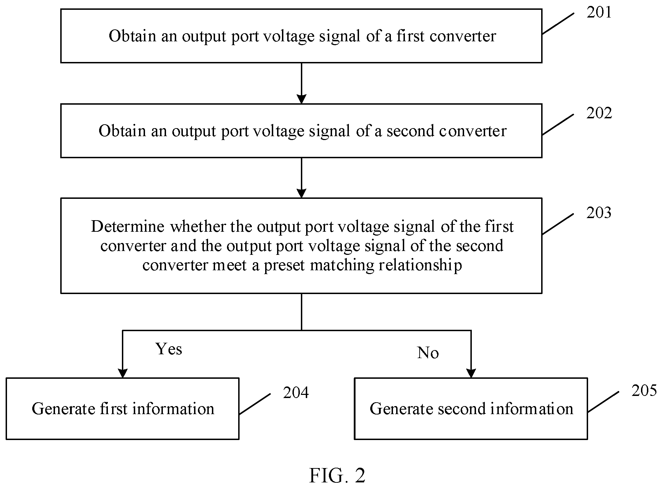

In view of this, embodiments of this application provide a detection method, so that whether there is a wiring error in a combiner system of converters can be quickly and accurately determined in an application scenario in which voltage information at a combiner point cannot be obtained. FIG. 2 is a flowchart of a detection method according to an embodiment of this application. The detection method is applicable to a case in which a first converter is working and a second converter is not working. The case in which the first converter is working and the second converter is not working is described in detail below.

In the wiring status shown in FIG. 1, two combiner systems are included. One combiner system includes the combiner device 101 and the converter 1 to the converter n, and the other combiner system includes the combiner device 102 and the converter n+1 to the converter 2n. In this embodiment of this application, the first combiner system is used as an example for description. For the other combiner system, refer to this implementation. Details are not described again in this embodiment of this application.

In the combiner system, the converter 1 to the converter n all need to be connected to the combiner device 101. Therefore, one of the converter 1 to the converter n may be selected as a master (which may also be referred to as a first converter), and another converter may be used as a slave (which may also be referred to as a non-master converter or a second converter). In this embodiment of this application, a primary controller may select one of the converter 1 to the converter n as the master. A selection manner may be: performing selection based on a specific algorithm or directly and randomly. This is not limited in this embodiment of this application. In actual application, the master may alternatively be selected by staff. This is not limited.

In this embodiment of this application, the primary controller may be an independent device, or may be a converter. For example, when the primary controller is an independent device, the primary controller communicates with each converter in a wireless or wired communication manner. For another example, when the primary controller is the converter 1, the primary controller may be implemented by a logic circuit in the converter 1, or may be implemented by a processor in the converter 1 by executing code in a memory, or may be implemented in another form. Details are not described in this application.

In this embodiment of this application, the primary controller may indicate the master (the first converter) to work and the slave (the second converter) not to work. Specifically, that the master works means that the converter works based on a function of the converter. For example, if the converter is an inverter (a direct current-to-alternating current converter, a DC/AC converter), that the converter works means that the inverter implements a function of converting a direct current into an alternating current. In another case, the converter may alternatively be a direct current-to-direct current converter (DC/DC converter) or an alternating current-to-direct current converter (AC/DC converter). This is not limited in this embodiment of this application. In some embodiments, a case in which the converter works each time is not necessarily the same, and a specific error is caused. Therefore, to detect a wiring error more accurately, the primary controller may indicate the master to output a preset disturbance signal (a disturbance signal for short below). For example, the primary controller may indicate the master to output a preset-waveform signal. In actual application, the primary controller may further indicate the master to output a direct-current signal, an alternating-current signal, and the like. This is not limited in this embodiment of this application.

In this embodiment of this application, when the converter is not working, a circuit/module that is on the converter and that is configured to detect an output port voltage signal of the converter is still powered on and runs, and may detect the output port voltage signal of the converter. Therefore, regardless of whether the master is working or the slave is not working, the converter can detect the output port voltage signal and report the output port voltage signal to the primary controller.

Based on the foregoing case, the primary controller may perform the following procedure:
201: Obtain an output port voltage signal of a first converter.

In this embodiment of this application, when the first converter is working, the output port voltage signal of the first converter may be a preset "disturbance signal". A detection circuit in the first converter may detect the output port voltage signal and upload the output port voltage signal to a primary controller, so that the primary controller obtains the output port voltage signal of the first converter.

In some embodiments, the primary controller may send an instruction to the first converter, to indicate the detection circuit in the first converter to detect the output port voltage signal and upload the output port voltage signal to the primary controller. In some other embodiments, the detection circuit in the first converter detects the output port voltage signal at intervals of a period of time and uploads the output port voltage signal to the primary controller. This is not limited in this embodiment of this application.

202: Obtain an output port voltage signal of a second converter.

In this embodiment of this application, when the second converter is not working, the detected output port voltage signal of the second converter may be referred to as a "characteristic signal". A detection circuit in the second converter may detect the output port voltage signal and upload the output port voltage signal to the primary controller, so that the primary controller obtains the output port voltage signal of the second converter.

In some embodiments, the primary controller may send an instruction to the second converter, to indicate the detection circuit in the second converter to detect the output port voltage signal and upload the output port voltage signal to the primary controller. In some other embodiments, the detection circuit in the second converter detects the output port voltage signal at intervals of a period of time and uploads the output port voltage signal to the primary controller. This is not limited in this embodiment of this application.

203: Determine whether the output port voltage signal of the first converter and the output port voltage signal of the second converter meet a preset matching relationship; and if yes, perform step 204; or if no, perform step 205.

In this embodiment of this application, after receiving the output port voltage signal (which may also be referred to as a disturbance signal or a disturbance voltage) of the first converter and the output port voltage signal (which may also be referred to as a characteristic signal or a characteristic voltage) of the second converter, the primary controller may determine whether the output port voltage signal of the first converter and the output port voltage signal of the second converter meet the preset matching relationship.

The matching relationship may be an amplitude relationship, a phase relationship, a frequency relationship, or the like. This is not limited in this embodiment of this application. The amplitude relationship is used as an example below for description. For another case, refer to this embodiment of this application. Details are not described again. For example, that the disturbance signal and the characteristic signal meet the preset matching relationship may be that an absolute value of a difference between a voltage amplitude of the disturbance signal and a voltage amplitude of the characteristic signal is less than a fault threshold. For example, the voltage amplitude of the disturbance signal is 10 V, the voltage amplitude of the characteristic signal is 10.1 V, and the fault threshold is 1 V; and in this case, the absolute value of the difference between the voltage amplitude of the disturbance signal and the voltage amplitude of the characteristic signal is 0.1 V, and is less than the fault threshold 1 V. Therefore, the primary controller may determine, based on this case, that the output port voltage signal (the disturbance signal) of the first converter and the output port voltage signal (the characteristic signal) of the second converter meet the preset matching relationship. In actual application, another specified matching relationship may also be used to implement the solution in this application. This is not limited in this embodiment of this application.

In actual application, whether the disturbance signal and the characteristic signal meet the preset matching relationship may be specifically determined in the following manner: First, a component amplitude of the output port voltage signal of the first converter at a specified frequency is obtained, for example, it is determined from an output port voltage of the first converter that a component amplitude at 20 Hz is U1A_PE. Then, a component amplitude of the output port voltage signal of the second converter at the specified frequency is obtained, for example, it is determined from an output port voltage of the second converter that a component amplitude at 20 Hz is U2A_PE. Then, whether a difference between U1A_PE and U2A_PE exceeds a preset fault threshold is determined through comparison. In actual application of this solution, there may alternatively be another matching relationship. This is not limited in this embodiment of this application.

When there are only the first converter (the master) and the second converter (the slave) in a combiner system, if the output port voltage signal of the first converter and the output port voltage signal of the second converter meet the preset matching relationship, the primary controller may determine that wire connections of the first converter and the second converter are correct, and perform step 204. If the output port voltage signal of the first converter and the output port voltage signal of the second converter do not meet the preset matching relationship, the primary controller may determine that a wire connection of the first converter or the second converter is incorrect, and perform step 205.

When there are the first converter (the master) and a plurality of second converters (slaves) in the combiner system, the primary controller may simultaneously determine whether the output port voltage signal of the first converter and output port voltage signals of the plurality of second converters meet the preset matching relationship. If the output port voltage signal of the first converter and the output port voltage signals of all the plurality of second converters meet the preset matching relationship, it indicates that the first converter and the plurality of second converters are all connected to a same combiner device, and the primary controller determines that wire connections of all the first converter and the plurality of second converters are correct, and performs step 204. In some embodiments, if it is determined that the output port voltage signal of the first converter and an output port voltage signal of one of the second converters do not meet the preset matching relationship, it indicates that the first converter and the second converter are not connected to a same combiner device, and a wire connection of one of the converters (the first converter or the second converter) is definitely incorrect. In this case, the primary controller may perform step 205.

It may be understood that the matching relationship may be a database that is preset in the primary controller. When performing step 203, the primary controller may read a related matching relationship from the database and perform corresponding calculation and determining. This is not limited in this embodiment of this application.

204: Generate first information.

When the primary controller determines that the output port voltage signal of the first converter and the output port voltage signal of the second converter meet a preset matching relationship, the primary controller may generate the first information. In this embodiment of this application, the first information indicates that an output port of the first converter and an output port of the second converter are connected to a same combiner device.

It may be understood that, when the output port voltage signal of the first converter and the output port voltage signal of the second converter meet the preset matching relationship, it indicates that the output port of the first converter and the output port of the second converter are connected to the same combiner device, and the primary controller may generate the first information, and present the first information to wiring staff or perform further processing based on the first information.

The presenting the first information to the wiring staff may be: associating numbers of the first converter and the second converter (for example, connecting the numbers or setting the numbers to same color), so that the staff may determine that the first converter and the second converter are connected to the same combiner device. When there are the first converter (the master) and a plurality of second converters (slaves) in the combiner system, the primary controller may present first information of the first converter and first information of the second converters one by one or jointly, so that the staff may determine that the first converter and the plurality of second converters are all connected to a same combiner device, and determine that wire connections of all the first converter and the plurality of second converters are correct.

When the primary controller performs further processing, the primary controller may determine, based on an indication of the first information, that the first converter and the second converter are connected to the same combiner device, to perform an operation that can be performed in this condition. For example, the primary controller may start the entire combiner system only after determining that wire connections of all the converters in the combiner system are correct, and the primary controller starts the entire combiner system only after obtaining the first information of the first converter and the first information of all the second converters.

205: Generate second information.

When the primary controller determines that the output port voltage signal of the first converter and the output port voltage signal of the second converter do not meet the preset matching relationship, the primary controller may generate the second information. In this embodiment of this application, the second information indicates that an output port of the first converter and an output port of the second converter are connected to different combiner devices, and that a wire connection of the first converter is incorrect or a wire connection of the second converter is incorrect.

It may be understood that, when there are only the first converter (the master) and the second converter (the slave) in the combiner system, if it is determined that the output port voltage signal of the first converter and an output port voltage signal of the second converter do not meet the preset matching relationship, it indicates that the first converter and the second converter are not connected to a same combiner device, and a wire connection of one of the converters (the first converter or the second converter) is definitely incorrect. In this case, the primary controller may generate the second information.

When there are the first converter (the master) and a plurality of second converters (slaves) in the combiner system, the primary controller may simultaneously determine whether the output port voltage signal of the first converter and output port voltage signals of the plurality of second converters meet the preset matching relationship. If it is determined that the output port voltage signal of the first converter and an output port voltage signal of one of the second converters do not meet the preset matching relationship, it indicates that the first converter and the second converter are not connected to a same combiner device, and a wire connection of one of the converters (the first converter or the second converter) is definitely incorrect. In this case, the primary controller may generate the second information.

After generating the second information, the primary controller may present the second information to wiring staff or perform further processing based on the second information.

The presenting the second information to the wiring staff may be: counterposing numbers of the first converter and the second converter (for example, setting the numbers to different color or separately marking the numbers with a tick and a cross), so that the staff may clearly know that a wire connection of the first converter or the second converter is incorrect. The staff can learn, by using the presented second information, that the wire connection of the first converter or the second converter is incorrect, and may check the first converter or the second converter. In some cases, when there are the first converter (the master) and a plurality of second converters (slaves) in the combiner system, the primary controller may present second information of the first converter and second information of several second converters, and present first information of the other second converters. In this case, the staff may generally determine that wire connections of the "several second converters" are incorrect.

When the primary controller performs further processing, the primary controller may determine, based on an indication of the second information, that the first converter and the second converter are not connected to the same combiner device, and then perform an operation that can be performed in this condition. For example, if the primary controller may determine that a specific second converter and the first converter in the combiner system are not connected to a same combiner device, the primary controller may send an alarm to notify the staff that a wire connection of the second converter is incorrect.

In some embodiments, if wire connections of all the converters in the combiner system are correct, the primary controller may generate the first information based on the foregoing steps, but does not generate the second information (the second information is generated when the wire connection is incorrect). Therefore, if the primary controller generates the first information after performing the steps of the foregoing detection method on the combiner system, there is no wiring error in the combiner system.

In some other embodiments, if the selected first converter (the master) is exactly the only converter with an incorrect wire connection in the combiner system, the first converter and other second converters (slaves) are not connected to a same combiner system. In this case, the primary controller generates a plurality of pieces of second information, but does not generate the first information. Generally, wire connections of most converters are correct. Therefore, in this case, it is likely that the first converter is a converter with an incorrect wire connection, and wire connections of other second converters are correct. Therefore, the staff may focus on checking a wiring status of the first converter based on the first information and the second information, and can quickly determine a converter with an incorrect wire connection. In addition, the primary controller may reselect one of the second converters as a new master, and perform detection again.

It may be understood that when there are only two combiner systems in a system architecture, if the primary controller generates a plurality of pieces of second information but does not generate the first information, there are two possibilities. One possibility is that the first converter is incorrectly connected to the other combiner system, and other second converters are correctly connected to a current combiner system. The other possibility is that the first converter is correctly connected to the current combiner system, and other second converters are incorrectly connected to the other combiner system. In short, the staff perform actual determining based on the foregoing two cases.

In some embodiments, some second converters in the combiner system are not connected to a same combiner device as the first converter. In this case, after performing the foregoing detection method, the primary controller can generate several pieces of first information and several pieces of second information, and present the information. After viewing the first information and the second information, the staff may focus on checking a converter corresponding to the second information, and determine a converter with an incorrect wire connection.

In some embodiments, the primary controller may directly determine that a converter corresponding to the first information is a converter with a correct wire connection, and the converter corresponding to the second information is the converter with an incorrect wire connection, and send an alarm to notify the staff of "the converter with an incorrect wire connection". Specifically, the primary controller may present a number of the converter with an incorrect wire connection on a display screen, or may configure corresponding indicators for all converters. If a wire connection of the converter is correct, the indicator is presented in green; and if the wire connection of the converter is incorrect, the indicator is presented in red. In actual application, the primary controller may alternatively perform presentation in another form. This is not limited in this embodiment of this application.

In this embodiment of this application, the combiner device may be a device configured to combine outputs of the converters, such as a combiner power distribution cabinet, a split winding transformer, or a combiner box. This is not limited in this embodiment of this application.

In this embodiment of this application, the converter may be a direct current-to-direct current converter, a direct current-to-alternating current converter, an alternating current-to-direct current converter, or the like. This is not limited in this embodiment of this application.

In this embodiment of this application, the primary controller may communicate with each converter by using a wireless signal or in a wired manner, so that the primary controller can obtain an output port voltage signal of each converter from the converter.

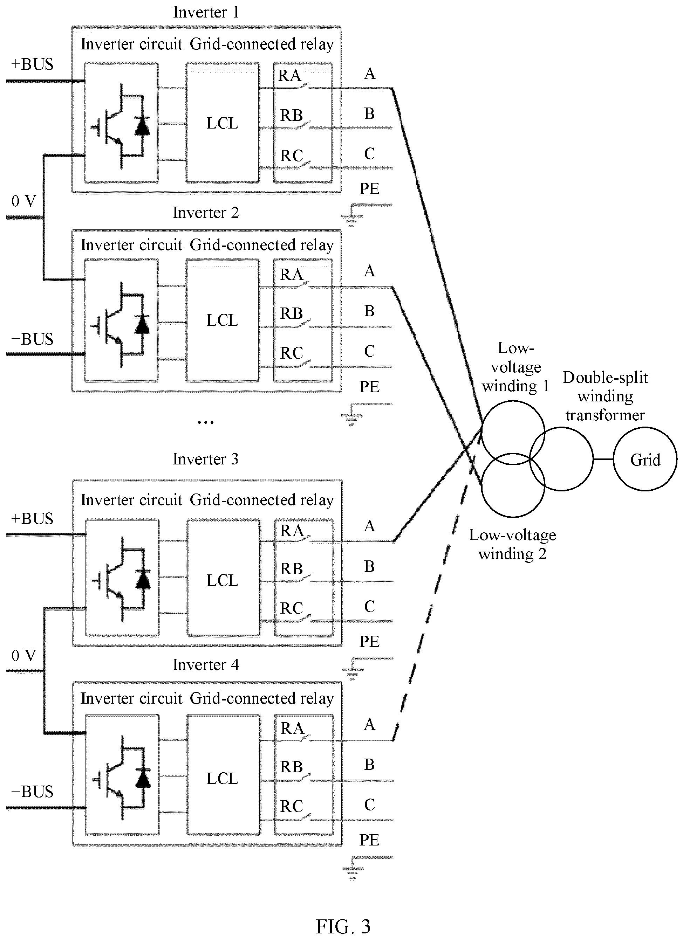

FIG. 3 is a schematic diagram of a system architecture in an application example according to this application. In the system architecture, a converter is specifically an inverter, and direct-current sides of inverters are connected in series and installed in pairs. A combiner device is a transformer winding, and a low-voltage winding 1 and a low-voltage winding 2 are different combiner devices. A communication manner between inverters and a communication manner between the inverter and a primary controller are alternating-current power line carrier communication (PLC).

In FIG. 3, direct-current sides of inverters are connected in series and installed in pairs. As shown by an inverter 1 and an inverter 2 in FIG. 3, direct-current side inputs of the inverter 1 are +BUS and 0 V, and direct-current side inputs of the inverter 2 are 0 V and -BUS. Because the direct-current side of the inverter 1 and the direct-current side of the inverter 2 are connected in series as an input, outputs of the inverter 1 and the inverter 2 need to be isolated by two groups of low-voltage windings of a dual-split winding transformer. Otherwise, a bus is short-circuited during running. Therefore, in this application example, an inverter with direct-current inputs of +BUS and 0 V is usually preset to be connected to a low-voltage winding 1 (a combiner system 1 for short below), and an inverter with direct-current inputs of 0 V and -BUS is preset to be connected to a low-voltage winding 2 (a combiner system 2 for short below). Therefore, the system architecture shown in FIG. 3 actually includes two combiner systems. In the combiner system 1, inverters with direct-current inputs of +BUS and 0 V are combined by using the low-voltage winding 1, and in the combiner system 2, inverters with direct-current inputs of 0 V and -BUS are combined by using the low-voltage winding 2.

In FIG. 3, the inverter 1 and an inverter 3 are inverters with direct-current inputs of +BUS and 0 V, and need to be connected to the low-voltage winding 1, and the inverter 2 and an inverter 4 are inverters with direct-current inputs of 0 V and -BUS, and need to be connected to the low-voltage winding 2. However, a current wiring status is that the inverter 4 is incorrectly connected to the low-voltage winding 1, and once the inverter 4 is started and runs, BUS+ and BUS- are short-circuited and damaged. Therefore, a similar wiring error needs to be accurately identified.

### 1. About the combiner system 1:

The inverter 1 and the inverter 3 are two inverters that are preset to be connected to the combiner system 1. A phase-A grid-connected relay RA of the inverter 1 is closed, and a phase-A bridge arm of the inverter 1 works, to control a phase A to output a sine wave with an amplitude of 50 V and a frequency of 20 Hz. The inverter may generally collect a voltage of an output end to PE, obtain a voltage of the phase A to PE through sampling, obtain a 20 Hz component amplitude of the voltage through calculation, and use this value as a disturbance voltage amplitude, where the 20 Hz component amplitude is denoted as U1A_PE. The inverter 1 transfers the disturbance voltage amplitude to the primary controller. A voltage of a phase A of the inverter 3 to PE is detected, and a 20 Hz component amplitude obtained after same processing is denoted as U3A_PE. This value is used as a characteristic voltage amplitude. The inverter 3 transfers the characteristic voltage amplitude to the primary controller. After receiving feedbacks from the inverter 1 and the inverter 3, the primary controller performs comparison. If an absolute value of a difference between the characteristic voltage magnitude and the disturbance voltage magnitude is less than a fault threshold, it indicates that the inverter 3 and the inverter 1 are connected to a same combiner system. If the difference between the characteristic voltage magnitude and the disturbance voltage magnitude is greater than the fault threshold, it indicates that the inverter 1 and the inverter 3 are not connected to a same combiner system. It can be learned from FIG. 3 that, wire connections of the inverter 1 and the inverter 3 are correct, and therefore a voltage difference between the inverter 1 and the inverter 3 is less than the fault threshold. Herein, a value of the fault threshold is 20 V

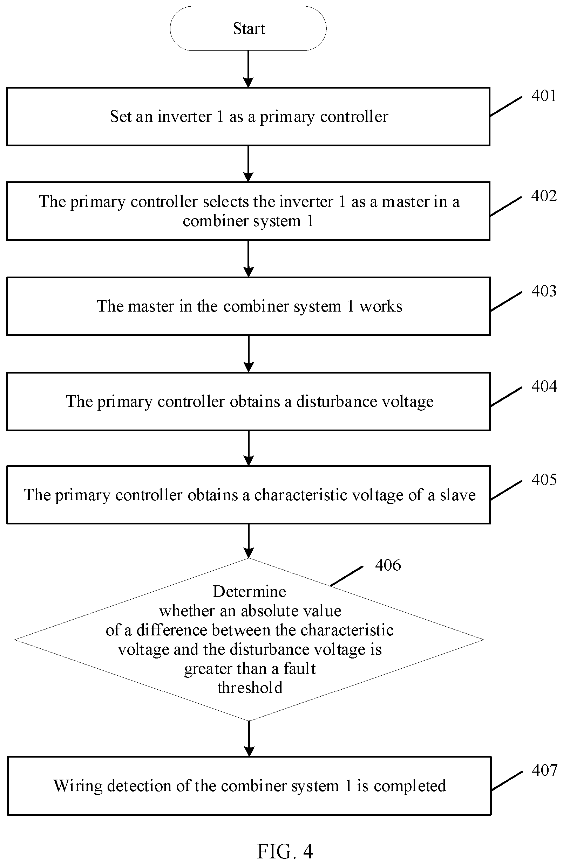

In the detection method provided in this application, the primary controller collects an output port voltage signal of each inverter, and determines, based on the voltage signal, an inverter with an incorrect wire connection in the combiner system. Specifically, FIG. 4 is a schematic diagram of detection steps for the combiner system 1 in an application example of this application. The detection steps include the following steps.

401: Set the inverter 1 as the primary controller.

In this application example, staff may preset the inverter 1 as the primary controller.

402: The primary controller selects the inverter 1 as a master in the combiner system 1.

In this application example, the master is the foregoing first converter, and a slave is the foregoing second converter.

403: The master in the combiner system 1 works.

The master in the combiner system 1 controls a grid-connected relay RA to be closed. In this application example, the grid-connected relay RA may be closed to connect to a phase-A line of the inverter 1, so that the inverter 1 works.

404: The primary controller obtains a disturbance voltage.

A phase-A inverter bridge arm of the inverter works, controls a phase A to output a sine wave with an amplitude of 50 V and a frequency of 20 Hz, detects a voltage of the phase A to PE, and calculates a 20 Hz component amplitude U1A_PE in the voltage. The voltage amplitude is a disturbance voltage amplitude. The master transfers the disturbance voltage amplitude to the primary controller.

405: The primary controller obtains a characteristic voltage of the slave.

The slave in the combiner system 1 detects a voltage of the phase A to PE and calculates a 20 Hz component amplitude UxA_PE (x is a number of the slave in the combiner system 1, for example, a component amplitude of the inverter 3 is denoted as U3A_PE) in the voltage. The voltage amplitude is a characteristic voltage amplitude. The slave transfers the characteristic voltage amplitude to the primary controller.

406: The primary controller determines whether an absolute value of a difference between the characteristic voltage and the disturbance voltage is greater than a fault threshold.

The primary controller receives characteristic voltage amplitudes of all slaves in the combiner system 1, and compares the characteristic voltage amplitudes with the disturbance voltage amplitude. If an absolute value of a difference between the characteristic voltage amplitude and the disturbance voltage amplitude is greater than the fault threshold, it indicates that there is a wiring error in the combiner system 1. A value of the fault threshold is 20 V.

In this application example, a voltage difference between the inverter 1 and the inverter 3 is less than the fault threshold. Therefore, the primary controller may determine that wire connections of the inverter 1 and the inverter 3 are correct. In some cases, the primary controller may generate and present first information (used to indicate that the wire connections of the inverter 1 and the inverter 3 are correct). After seeing the first information, the staff can clearly know that the wire connections of the inverter 1 and the inverter 3 are correct.

407: Wiring detection of the combiner system 1 is completed.

After the wiring detection of the combiner system 1 is completed, the primary controller may send a shutdown command to the master in the combiner system 1 to shut down the master in the combiner system 1.

### 2. About the combiner system 2:

The primary controller may further perform same detection on an inverter 2 and an inverter 4 that are preset to be connected to the combiner system 2. Specifically, first, a phase-A grid-connected relay RA of the inverter 2 is closed, a phase-A bridge arm of the inverter 2 works, and a phase A is controlled to output a sine wave with an amplitude of 50 V and a frequency of 20 Hz. After a voltage of the phase A to PE is obtained through sampling, a 20 Hz component amplitude in the voltage is obtained through calculation and is denoted as U2A_PE. This value is used as a disturbance voltage amplitude. The inverter 2 transfers the disturbance voltage amplitude to the primary controller. Then, a voltage of a phase A of the inverter 4 to PE is detected, and a 20 Hz component amplitude obtained after same processing is denoted as U4A_PE. This value is used as a characteristic voltage amplitude. The inverter 4 transfers the characteristic voltage amplitude to the primary controller. After receiving feedbacks from the inverter 2 and the inverter 4, the primary controller performs comparison. In the application example of FIG. 3, because a wire connection of the inverter 4 is incorrect, an absolute value of a difference between the disturbance voltage amplitude from the inverter 2 and the characteristic voltage amplitude from the inverter 4 is greater than a fault threshold, and therefore, the primary controller may determine a wiring error, and then generate a wiring error alarm.

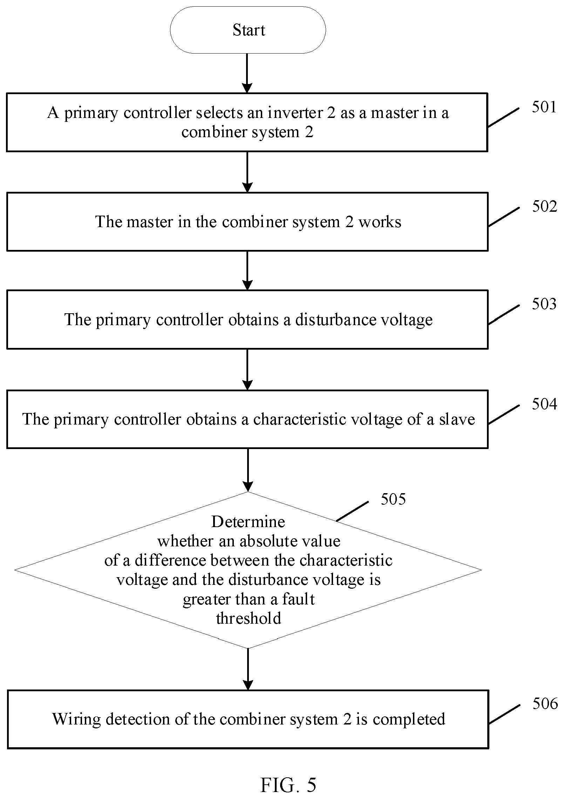

Specifically, FIG. 5 is a schematic diagram of detection steps for the combiner system 2 in an application example of this application. The detection steps include the following steps.

501: The primary controller selects the inverter 2 as a master in the combiner system 2.

In this application example, in the system architecture in FIG. 3, if the inverter 1 is selected as the primary controller in advance, the primary controller does not need to be determined again. Because inverters may communicate with each other through PLC, the primary controller may normally receive output port voltage signals of the inverter 2, the inverter 4, and the like.

In this application example, the inverter 2 is selected as the master in the combiner system 2, and other inverters in the combiner system 2 are slaves.

502: The master in the combiner system 2 works.

In this application example, the master in the combiner system 2 controls a grid-connected relay RA to be closed.

503: The primary controller obtains a disturbance voltage.

A phase-A inverter bridge arm of the inverter works, and the phase A is controlled to output a sine wave of an amplitude of 50 V and a frequency of 20 Hz. The master detects a voltage of the phase A to PE and calculates a 20 Hz component amplitude U2A_PE in the voltage. The voltage amplitude is a disturbance voltage amplitude. The master transfers the disturbance voltage amplitude to the primary controller.

504: The primary controller obtains a characteristic voltage of the slave.

The slave in the combiner system 2 detects a voltage of the phase A to PE and calculates a 20 Hz component amplitude UyA_PE (y is a number of the slave in the combiner system 2, for example, a component amplitude of the inverter 4 is denoted as U4A_PE) in the voltage. The voltage amplitude is a characteristic voltage amplitude. The slave transfers the characteristic voltage amplitude to the primary controller.

505: The primary controller determines whether an absolute value of a difference between the characteristic voltage and the disturbance voltage is greater than a fault threshold.

The primary controller receives characteristic voltage amplitudes of all slaves in the combiner system 2, and compares the characteristic voltage amplitudes with the disturbance voltage amplitude. If an absolute value of a difference between the characteristic voltage amplitude and the disturbance voltage amplitude is greater than the fault threshold, it indicates that there is a wiring error in the combiner system 2. A value of the fault threshold is 20 V.

In this application example, because an absolute value of a difference between the disturbance voltage amplitude from the inverter 2 and the characteristic voltage amplitude from the inverter 4 is greater than the fault threshold, the primary controller may determine a wiring error, and then generate a wiring error alarm. Before the system architecture shown in FIG. 3 is started and runs, staff may check whether there is alarm information. If there is alarm information, the staff checks a wire connection first. In some cases, the staff may further focus on checking of wiring errors of the inverter 2 and the inverter 4 based on the alarm information.

506: Wiring detection of the combiner system 2 is completed.

After the wiring detection of the combiner system 2 is completed, the primary controller may send a shutdown command to the master in the combiner system 2 to shut down the master in the combiner system 2.

In this case, wiring error detection for the system shown in FIG. 3 is completed.

It can be learned from the foregoing embodiments and application examples that the detection solution provided in embodiments of this application has the following advantages:
1. A wiring error detection solution can be applied to different types of combiner devices.
   Reasons are as follows: The master injects a disturbance voltage as a detection signal, and a lower-level device in the combiner system does not need to be powered on; and for a plurality of coupled combiner systems, disturbance voltages can be injected at different times and detected separately.
2. In this wiring error detection solution, information at a combiner point of the combiner device is not required, and the detection solution is simple. A reason is as follows: A wiring detection criterion depends only on port voltage information of each converter, voltage information can be uploaded to the primary controller only by using an existing hardware circuit of the inverter, and the information at the combiner point of the combiner device is not required. This avoids a complex design caused by detection of the information at the combiner point.

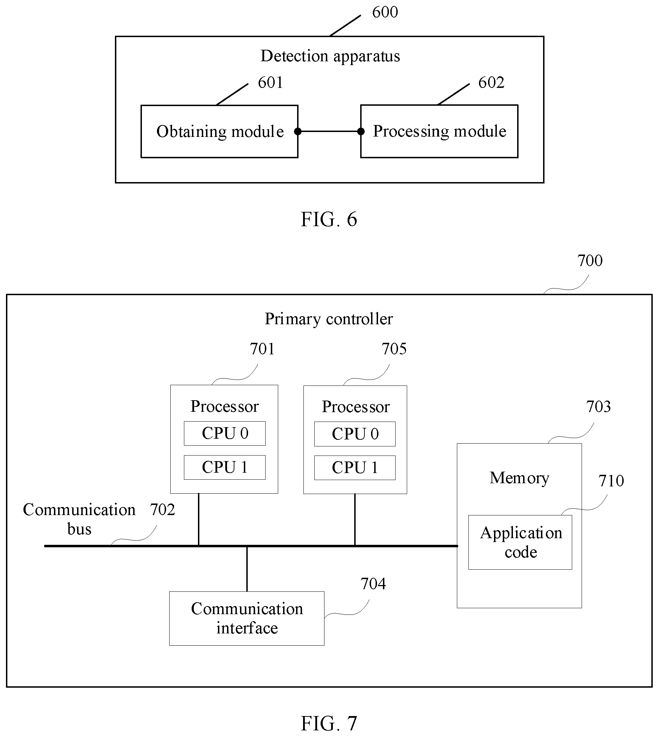

FIG. 6 is a schematic diagram of a detection apparatus according to an embodiment of this application. A detection apparatus 600 includes:
an obtaining module 601, configured to perform step 201 and step 202 in the embodiments corresponding to FIG. 2; and
a processing module 602, configured to perform step 203, step 204, and step 205 in the embodiments corresponding to FIG. 2.

FIG. 7 is a schematic diagram of an architecture of a primary controller according to an embodiment of this application. A primary controller 700 includes one or more processors 701, a memory 703, and a communication interface 704, and the processor 701, the memory 703, and the communication interface 704 may be connected by using a communication bus 702. The memory 703 is configured to store one or more programs. The one or more processors 701 are configured to run the one or more programs, so that the primary controller 700 performs the method corresponding to the foregoing method embodiments.

The processor 701 may be a general-purpose central processing unit (central processing unit, CPU), a network processor (network processor, NP), a microprocessor, or one or more integrated circuits configured to implement the solutions in this application, for example, an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable logic gate array (field-programmable gate array, FPGA), generic array logic (generic array logic, GAL), or any combination thereof.

The communication bus 702 is configured to transmit information between the foregoing components. The communication bus 702 may be classified into an address bus, a data bus, a control bus, and the like. For ease of representation, only one thick line is used to represent the bus in FIG. 7, but this does not mean that there is only one bus or only one type of bus.

The memory 703 may be a read-only memory (read-only memory, ROM) or another type of static storage device capable of storing static information and instructions, or may be a random access memory (random access memory, RAM) or another type of dynamic storage device capable of storing information and instructions, or may be an electrically erasable programmable read-only memory (electrically erasable programmable read-only Memory, EEPROM), a compact disc read-only memory (compact disc read-only memory, CD-ROM) or another compact disc storage, an optical disc storage (including a compressed optical disc, a laser disc, an optical disc, a digital versatile optical disc, a Blu-ray optical disc, or the like), a magnetic disk storage medium or another magnetic storage device, or any other medium capable of carrying or storing expected program code in a form of instructions or a data structure and capable of being accessed by a computer. The memory 703 is not limited thereto. The memory 703 may exist independently, and is connected to the processor 701 by using the communication bus 702. Alternatively, the memory 703 may be integrated with the processor 701.

The communication interface 704 is configured to communicate with another device or a communication network by using any apparatus such as a transceiver. The communication interface 704 includes a wired communication interface, and may further include a wireless communication interface. The wired communication interface may be, for example, an Ethernet interface. The Ethernet interface may be an optical interface, an electrical interface, or a combination thereof. The wireless communication interface may be, for example, a wireless local area network (wireless local area network, WLAN) interface, a cellular network communication interface, or a combination thereof.

In specific implementation, in an embodiment, the processor 701 may include one or more CPUs, for example, a CPU 0 and a CPU 1 shown in FIG. 7.

In specific implementation, in an embodiment, the primary controller 700 may include a plurality of processors, for example, the processor 701 and a processor 705 shown in FIG. 7. Each of the processors may be a single-core processor (single-CPU) or a multi-core processor (multi-CPU). The processor herein may be one or more devices, circuits, and/or processing cores configured to process data (for example, computer program instructions).

In specific implementation, in an embodiment, the primary controller 700 may further include an output device and an input device. The output device communicates with the processor 701, and may display information in a plurality of manners. For example, the output device may be a liquid crystal display (liquid crystal display, LCD), a light emitting diode (light emitting diode, LED) display device, a cathode ray tube (cathode ray tube, CRT) display device, or a projector (projector). The input device communicates with the processor 701, and may receive an input from a user in a plurality of manners. For example, the input device may be a mouse, a keyboard, a touchscreen device, or a sensing device.

In some embodiments, the memory 703 is configured to store program code 710 for performing the solutions in this application, and the processor 701 may execute the program code 710 stored in the memory 703. In other words, the primary controller 700 may implement, by using the processor 701 and the program code 710 in the memory 703, the detection method provided in the method embodiments.

The primary controller 700 in this embodiment of this application may correspond to the primary controller in the foregoing method embodiments, and the processor 701, the communication interface 704, and the like in the primary controller 700 may implement functions of the primary controller in the foregoing method embodiments and/or various steps and methods implemented by the primary controller in the foregoing method embodiments. For brevity, details are not described herein again.

## Claims

1. A detection method, comprising:
obtaining, by a primary controller (700) an output port voltage signal of a first converter when the first converter (1) is working and a second converter (2) is not working;
obtaining, by the primary controller, an output port voltage signal of the second converter; and
generating, by the primary controller, first information if the output port voltage signal of the first converter and the output port voltage signal of the second converter meet a preset matching relationship, wherein the first information indicates that an output port of the first converter and an output port of the second converter are connected to a same combiner device (101); ; or
generating, by the primary controller, second information if the output port voltage signal of the first converter and the output port voltage signal of the second converter do not meet a preset matching relationship, wherein the second information indicates that the output port of the first converter and the output port of the second converter are connected to different combiner devices, and that a wire connection of the first converter is incorrect or a wire connection of the second converter is incorrect.

2. The method according to claim 1, wherein before the primary controller indicates the first converter to start working, the method further comprises:
determining, by the primary controller, the first converter from a plurality of converters in a combiner system according to an input instruction, wherein the combiner system comprises the first converter, the second converter, and a combiner device configured to combine the plurality of converters.

3. The method according to claim 2, wherein the combiner device for combining the plurality of converters is one of a combiner power distribution cabinet and a split winding transformer.

4. The method according to any one of claims 1 to 3, wherein the voltage signal is one of a direct-current signal, an alternating-current signal, or a preset-waveform signal.

5. The method according to any one of claims 1 to 4, wherein the converter is one of a direct current-to-direct current converter, a direct current-to-alternating current converter, or an alternating current-to-direct current converter.

6. The method according to any one of claims 1 to 5, wherein the primary controller communicates with the first converter and the second converter by using a wireless signal or in a wired manner.

7. The method according to any one of claims 1 to 6, wherein the matching relationship is one of an amplitude relationship, a phase relationship, or a frequency relationship.

8. The method according to any one of claims 1 to 7, wherein that the output port voltage signal of the first converter and the output port voltage signal of the second converter meet a preset matching relationship specifically comprises:
a difference between an output port voltage amplitude of the first converter and an output port voltage amplitude of the second converter is less than a preset fault threshold; and
that the output port voltage signal of the first converter and the output port voltage signal of the second converter do not meet a preset matching relationship specifically comprises:
the difference between the output port voltage amplitude of the first converter and the output port voltage amplitude of the second converter is not less than the preset fault threshold.

9. A primary controller (700) comprising a processor (701,705), a memory (703), and a communication interface (704), wherein
the memory stores a computer program;
the communication interface is configured to communicate with a converter; and
the processor is configured to execute the computer program stored in the memory, so that the primary controller implements the method according to any one of claims 1 to 8.

10. A detection apparatus, wherein the apparatus comprises:
an obtaining module (601), configured to obtain an output port voltage signal of a first converter (1)
and an output port voltage signal of a second converter (2)
when the first converter is working and the second converter is not working; and
a processing module (602), configured to generate first information when the output port voltage signal of the first converter and the output port voltage signal of the second converter meet a preset matching relationship, wherein the first information indicates that an output port of the first converter and an output port of the second converter are connected to a same combiner device (101); and
the processing module is further configured to generate second information when the output port voltage signal of the first converter and the output port voltage signal of the second converter do not meet the preset matching relationship, wherein the second information indicates that the output port of the first converter and the output port of the second converter are connected to different combiner devices, and that a wire connection of the first converter is incorrect or a wire connection of the second converter is incorrect.

11. The apparatus according to claim 10, wherein the processing module is further configured to:
determine the first converter from a plurality of converters in a combiner system according to an input instruction, wherein the combiner system comprises the first converter, the second converter, and a combiner device configured to combine the plurality of converters.

12. The apparatus according to claim 11, wherein the combiner device for combining the plurality of converters is one of a combiner power distribution cabinet and a split winding transformer.

13. The apparatus according to any one of claims 10 to 12, wherein the voltage signal is one of a direct-current signal, an alternating-current signal, or a preset-waveform signal.

14. The apparatus according to any one of claims 10 to 13, wherein the converter is one of a direct current-to-direct current converter, a direct current-to-alternating current converter, or an alternating current-to-direct current converter.

15. The apparatus according to any one of claims 10 to 14, wherein that the output port voltage signal of the first converter and the output port voltage signal of the second converter meet a preset matching relationship specifically comprises:
a difference between an output port voltage amplitude of the first converter and an output port voltage amplitude of the second converter is less than a preset fault threshold; and
that the output port voltage signal of the first converter and the output port voltage signal of the second converter do not meet the preset matching relationship specifically comprises:
the difference between the output port voltage amplitude of the first converter and the output port voltage amplitude of the second converter is not less than the preset fault threshold.

## Patentansprüche

1. Detektionsverfahren, umfassend:
Erlangen, durch eine primäre Steuerung (700), eines Ausgabeanschlussspannungssignals eines ersten Konverters, wenn der erste Konverter (1) arbeitet und ein zweiter Konverter (2) nicht arbeitet;
Erlangen, durch die primäre Steuerung, eines Ausgabeanschlussspannungssignals des zweiten Konverters; und
Erzeugen, durch die primäre Steuerung, erster Informationen, falls das Ausgabeanschlussspannungssignal des ersten Konverters und das Ausgabeanschlussspannungssignal des zweiten Konverters eine voreingestellte Übereinstimmungsbeziehung erfüllen, wobei die ersten Informationen angeben, dass ein Ausgabeanschluss des ersten Konverters und ein Ausgabeanschluss des zweiten Konverters mit einer gleichen Kombinatorvorrichtung (101) verbunden sind; oder
Erzeugen, durch die primäre Steuerung, zweiter Informationen, falls das Ausgabeanschlussspannungssignal des ersten Konverters und das Ausgabeanschlussspannungssignal des zweiten Konverters eine voreingestellte Übereinstimmungsbeziehung nicht erfüllen, wobei die zweiten Informationen angeben, dass der Ausgabeanschluss des ersten Konverters und der Ausgabeanschluss des zweiten Konverters mit unterschiedlichen Kombinatorvorrichtungen verbunden sind und dass eine Kabelverbindung des ersten Konverters oder eine Kabelverbindung des zweiten Konverters falsch ist.

2. Verfahren nach Anspruch 1, wobei das Verfahren, bevor die primäre Steuerung dem ersten Konverter angibt, mit dem Arbeiten zu beginnen, ferner Folgendes umfasst:
Bestimmen, durch die primäre Steuerung, des ersten Konverters aus einer Vielzahl von Konvertern in einem Kombinatorsystem gemäß einer Eingabeanweisung, wobei das Kombinatorsystem den ersten Konverter, den zweiten Konverter und eine Kombinatorvorrichtung umfasst, die dazu konfiguriert ist, die Vielzahl von Konvertern zu kombinieren.

3. Verfahren nach Anspruch 2, wobei die Kombinatorvorrichtung zum Kombinieren der Vielzahl von Konvertern einer eines Kombinatorstromverteilerschranks und eines Wandlers mit geteilter Wicklung ist.

4. Verfahren nach einem der Ansprüche 1 bis 3, wobei das Spannungssignal eines von einem Gleichstromsignal, einem Wechselstromsignal oder einem Signal mit voreingestellter Wellenform ist.

5. Verfahren nach einem der Ansprüche 1 bis 4, wobei der Konverter einer eines Gleichstrom-zu-Gleichstrom-Wandlers, eines Gleichstrom-zu-Wechselstrom-Wandlers oder eines Wechselstrom-zu-Gleichstrom-Wandlers ist.

6. Verfahren nach einem der Ansprüche 1 bis 5, wobei die primäre Steuerung mit dem ersten Konverter und dem zweiten Konverter unter Verwendung eines drahtlosen Signals oder in einer verdrahteten Weise kommuniziert.

7. Verfahren nach einem der Ansprüche 1 bis 6, wobei die Übereinstimmungsbeziehung eine einer Amplitudenbeziehung, einer Phasenbeziehung oder einer Frequenzbeziehung ist.

8. Verfahren nach einem der Ansprüche 1 bis 7, wobei, dass das Ausgabeanschlussspannungssignal des ersten Konverters und das Ausgabeanschlussspannungssignal des zweiten Konverters eine voreingestellte Übereinstimmungsbeziehung erfüllen, speziell Folgendes umfasst:
eine Differenz zwischen einer Ausgabeanschlussspannungsamplitude des ersten Konverters und einer Ausgabeanschlussspannungsamplitude des zweiten Konverters ist geringer als ein voreingestellter Fehlerschwellenwert; und
dass das Ausgabeanschlussspannungssignal des ersten Konverters und das Ausgabeanschlussspannungssignal des zweiten Konverters eine voreingestellte Übereinstimmungsbeziehung nicht erfüllen, speziell Folgendes umfasst:
die Differenz zwischen der Ausgabeanschlussspannungsamplitude des ersten Konverters und der Ausgabeanschlussspannungsamplitude des zweiten Konverters ist nicht geringer als der voreingestellte Fehlerschwellenwert.

9. Primäre Steuerung (700), umfassend einen Prozessor (701, 705), einen Speicher (703) und eine Kommunikationsschnittstelle (704), wobei
der Speicher ein Computerprogramm speichert;
die Kommunikationsschnittstelle dazu konfiguriert ist, mit einem Konverter zu kommunizieren; und
der Prozessor dazu konfiguriert ist, das Computerprogramm, das in dem Speicher gespeichert ist, auszuführen, sodass die primäre Steuerung das Verfahren nach einem der Ansprüche 1 bis 8 umsetzt.

10. Detektionsgerät, wobei das Gerät Folgendes umfasst:
ein Erlangungsmodul (601), das dazu konfiguriert ist, ein Ausgabeanschlussspannungssignal eines ersten Konverters (1) und ein Ausgabeanschlussspannungssignal eines zweiten Konverters (2) zu erlangen, wenn der erste Konverter arbeitet und der zweite Konverter nicht arbeitet; und
ein Verarbeitungsmodul (602), das dazu konfiguriert ist, erste Informationen zu erzeugen, wenn das Ausgabeanschlussspannungssignal des ersten Konverters und das Ausgabeanschlussspannungssignal des zweiten Konverters eine voreingestellte Übereinstimmungsbeziehung erfüllen, wobei die ersten Informationen angeben, dass ein Ausgabeanschluss des ersten Konverters und ein Ausgabeanschluss des zweiten Konverters mit einer gleichen Kombinatorvorrichtung (101) verbunden sind; und
das Verarbeitungsmodul ferner dazu konfiguriert ist, zweite Informationen zu erzeugen, wenn das Ausgabeanschlussspannungssignal des ersten Konverters und das Ausgabeanschlussspannungssignal des zweiten Konverters die voreingestellte Übereinstimmungsbeziehung nicht erfüllen, wobei die zweiten Informationen angeben, dass der Ausgabeanschluss des ersten Konverters und der Ausgabeanschluss des zweiten Konverters mit unterschiedlichen Kombinatorvorrichtungen verbunden sind und dass eine Kabelverbindung des ersten Konverters oder eine Kabelverbindung des zweiten Konverters falsch ist.

11. Gerät nach Anspruch 10, wobei das Verarbeitungsmodul ferner zu Folgendem konfiguriert ist:
Bestimmen des ersten Konverters aus einer Vielzahl von Konvertern in einem Kombinatorsystem gemäß einer Eingabeanweisung, wobei das Kombinatorsystem den ersten Konverter, den zweiten Konverter und eine Kombinatorvorrichtung umfasst, die dazu konfiguriert ist, die Vielzahl von Konvertern zu kombinieren.

12. Gerät nach Anspruch 11, wobei die Kombinatorvorrichtung zum Kombinieren der Vielzahl von Konvertern einer eines Kombinatorstromverteilerschranks und eines Wandlers mit geteilter Wicklung ist.

13. Gerät nach einem der Ansprüche 10 bis 12, wobei das Spannungssignal eines von einem Gleichstromsignal, einem Wechselstromsignal oder einem Signal mit voreingestellter Wellenform ist.

14. Gerät nach einem der Ansprüche 10 bis 13, wobei der Konverter einer eines Gleichstrom-zu-Gleichstrom-Wandlers, eines Gleichstrom-zu-Wechselstrom-Wandlers oder eines Wechselstrom-zu-Gleichstrom-Wandlers ist.

15. Gerät nach einem der Ansprüche 10 bis 14, wobei, dass das Ausgabeanschlussspannungssignal des ersten Konverters und das Ausgabeanschlussspannungssignal des zweiten Konverters eine voreingestellte Übereinstimmungsbeziehung erfüllen, speziell Folgendes umfasst:
eine Differenz zwischen einer Ausgabeanschlussspannungsamplitude des ersten Konverters und einer Ausgabeanschlussspannungsamplitude des zweiten Konverters ist geringer als ein voreingestellter Fehlerschwellenwert; und
dass das Ausgabeanschlussspannungssignal des ersten Konverters und das Ausgabeanschlussspannungssignal des zweiten Konverters die voreingestellte Übereinstimmungsbeziehung nicht erfüllen, speziell Folgendes umfasst:
die Differenz zwischen der Ausgabeanschlussspannungsamplitude des ersten Konverters und der Ausgabeanschlussspannungsamplitude des zweiten Konverters ist nicht geringer als der voreingestellte Fehlerschwellenwert.

## Revendications

1. Procédé de détection, comprenant :
l'obtention, par un contrôleur primaire (700), d'un signal de tension de port de sortie d'un premier convertisseur lorsque le premier convertisseur (1) fonctionne et qu'un second convertisseur (2) ne fonctionne pas ;
l'obtention, par le contrôleur primaire, d'un signal de tension de port de sortie du second convertisseur ; et
la génération, par le contrôleur primaire, de premières informations si le signal de tension de port de sortie du premier convertisseur et le signal de tension de port de sortie du second convertisseur satisfont à une relation de correspondance prédéfinie, dans lequel les premières informations indiquent qu'un port de sortie du premier convertisseur et un port de sortie du second convertisseur sont connectés à un même dispositif de combinaison (101) ; ou
la génération, par le contrôleur primaire, de secondes informations si le signal de tension de port de sortie du premier convertisseur et le signal de tension de port de sortie du second convertisseur ne satisfont pas à une relation de correspondance prédéfinie, dans lequel les secondes informations indiquent que le port de sortie du premier convertisseur et le port de sortie du second convertisseur sont connectés à des dispositifs de combinaison différents, et qu'une connexion filaire du premier convertisseur est incorrecte ou qu'une connexion filaire du second convertisseur est incorrecte.

2. Procédé selon la revendication 1, dans lequel, avant que le contrôleur primaire indique au premier convertisseur de commencer à fonctionner, le procédé comprend également :
la détermination, par le contrôleur primaire, du premier convertisseur parmi une pluralité de convertisseurs dans un système de combinaison selon une instruction d'entrée, dans lequel le système de combinaison comprend le premier convertisseur, le second convertisseur et un dispositif de combinaison configuré pour combiner la pluralité de convertisseurs.

3. Procédé selon la revendication 2, dans lequel le dispositif de combinaison destiné à combiner la pluralité de convertisseurs est l'un d'une armoire de distribution d'énergie de combinaison et d'un transformateur à enroulement divisé.

4. Procédé selon l'une quelconque des revendications 1 à 3, dans lequel le signal de tension est l'un d'un signal de courant continu, d'un signal de courant alternatif ou d'un signal de forme d'onde prédéfinie.

5. Procédé selon l'une quelconque des revendications 1 à 4, dans lequel le convertisseur est l'un d'un convertisseur de courant continu en courant continu, d'un convertisseur de courant continu en courant alternatif ou d'un convertisseur de courant alternatif en courant continu.

6. Procédé selon l'une quelconque des revendications 1 à 5, dans lequel le contrôleur primaire communique avec le premier convertisseur et le second convertisseur à l'aide d'un signal sans fil ou de manière filaire.

7. Procédé selon l'une quelconque des revendications 1 à 6, dans lequel la relation de correspondance est l'une d'une relation d'amplitude, d'une relation de phase ou d'une relation de fréquence.

8. Procédé selon l'une quelconque des revendications 1 à 7, dans lequel le fait que le signal de tension de port de sortie du premier convertisseur et le signal de tension de port de sortie du second convertisseur satisfont à une relation de correspondance prédéfinie comprend spécifiquement :
une différence entre une amplitude de tension de port de sortie du premier convertisseur et une amplitude de tension de port de sortie du second convertisseur est inférieure à un seuil de défaut prédéfini ; et
le fait que le signal de tension de port de sortie du premier convertisseur et le signal de tension de port de sortie du second convertisseur ne satisfont pas à une relation de correspondance prédéfinie comprend spécifiquement :
la différence entre l'amplitude de tension de port de sortie du premier convertisseur et l'amplitude de tension de port de sortie du second convertisseur n'est pas inférieure au seuil de défaut prédéfini.

9. Contrôleur primaire (700) comprenant un processeur (701, 705), une mémoire (703) et une interface de communication (704), dans lequel
la mémoire stocke un programme informatique ;
l'interface de communication est configurée pour communiquer avec un convertisseur ; et
le processeur est configuré pour exécuter le programme informatique stocké dans la mémoire, de sorte que le contrôleur primaire met en œuvre le procédé selon l'une quelconque des revendications 1 à 8.

10. Appareil de détection, dans lequel l'appareil comprend :
un module d'obtention (601), configuré pour obtenir un signal de tension de port de sortie d'un premier convertisseur (1) et un signal de tension de port de sortie d'un second convertisseur (2) lorsque le premier convertisseur fonctionne et que le second convertisseur ne fonctionne pas ; et
un module de traitement (602), configuré pour générer des premières informations lorsque le signal de tension de port de sortie du premier convertisseur et le signal de tension de port de sortie du second convertisseur satisfont à une relation de correspondance prédéfinie, dans lequel les premières informations indiquent qu'un port de sortie du premier convertisseur et un port de sortie du second convertisseur sont connectés à un même dispositif de combinaison (101) ; et
le module de traitement est également configuré pour générer des secondes informations quand le signal de tension de port de sortie du premier convertisseur et le signal de tension de port de sortie du second convertisseur ne satisfont pas à une relation de correspondance prédéfinie, dans lequel les secondes informations indiquent que le port de sortie du premier convertisseur et le port de sortie du second convertisseur sont connectés à des dispositifs de combinaison différents, et qu'une connexion filaire du premier convertisseur est incorrecte ou qu'une connexion filaire du second convertisseur est incorrecte.

11. Appareil selon la revendication 10, dans lequel le module de traitement est spécifiquement configuré pour :
déterminer le premier convertisseur parmi une pluralité de convertisseurs dans un système de combinaison selon une instruction d'entrée, dans lequel le système de combinaison comprend le premier convertisseur, le second convertisseur et un dispositif de combinaison configuré pour combiner la pluralité de convertisseurs.

12. Appareil selon la revendication 11, dans lequel le dispositif de combinaison destiné à combiner la pluralité de convertisseurs est l'un d'une armoire de distribution d'énergie de combinaison et d'un transformateur à enroulement divisé.

13. Appareil selon l'une quelconque des revendications 10 à 12, dans lequel le signal de tension est l'un d'un signal de courant continu, d'un signal de courant alternatif ou d'un signal de forme d'onde prédéfinie.

14. Appareil selon l'une quelconque des revendications 10 à 13, dans lequel le convertisseur est l'un d'un convertisseur de courant continu en courant continu, d'un convertisseur de courant continu en courant alternatif ou d'un convertisseur de courant alternatif en courant continu.

15. Appareil selon l'une quelconque des revendications 10 à 14, dans lequel le fait que le signal de tension de port de sortie du premier convertisseur et le signal de tension de port de sortie du second convertisseur satisfont à une relation de correspondance prédéfinie comprend spécifiquement :
une différence entre une amplitude de tension de port de sortie du premier convertisseur et une amplitude de tension de port de sortie du second convertisseur est inférieure à un seuil de défaut prédéfini ; et
le fait que le signal de tension de port de sortie du premier convertisseur et le signal de tension de port de sortie du second convertisseur ne satisfont pas à la relation de correspondance prédéfinie comprend spécifiquement :
la différence entre l'amplitude de tension de port de sortie du premier convertisseur et l'amplitude de tension de port de sortie du second convertisseur n'est pas inférieure au seuil de défaut prédéfini.
